(19) **Europäisches Patentamt / European Patent Office / Office européen des brevets**

(11) **EP 1 835 347 A1**

(12) # EUROPEAN PATENT APPLICATION
published in accordance with Art. 158(3) EPC

(43) Date of publication:
**19.09.2007 Bulletin 2007/38**

(51) Int Cl.:
**G03F 7/20** (2006.01)

(21) Application number: **04748966.1**

(22) Date of filing: **13.07.2004**

(86) International application number:
**PCT/RU2004/000273**

(87) International publication number:
**WO 2005/006082 (20.01.2005 Gazette 2005/03)**

(84) Designated Contracting States:
**AT BE BG CH CY CZ DE DK EE ES FI FR GB GR HU IE IT LI LU MC NL PL PT RO SE SI SK TR**

(30) Priority: **15.07.2003 RU 2003121347**
**12.04.2004 RU 2004110770**

(71) Applicant: **Ivanova, Natalia Viktorovna**
**Moscow, 129164 (RU)**

(72) Inventor: **Ivanova, Natalia Viktorovna**
**Moscow, 129164 (RU)**

(74) Representative: **Hano, Christian et al**
**v. Füner Ebbinghaus Finck Hano**
**Mariahilfplatz 2 & 3**
**81541 München (DE)**

(54) **IMAGE PRODUCING METHODS AND IMAGE PRODUCING DEVICES**

(57)    The invention relates to microlithography and can be used, for instance for producing integrated circuits or structures having a sub-micron resolution. An image is produced with the aid of the stepped displacement, including continuous displacement of the radiator matrix (es) and/or a material sensitive to a used radiation at a step which is less than d. The diameter of the radiation flux at the output of each radiator is less than 100 nm. The sizes of the radiator matrixes can be equal to or greater than an image size. The displacements are carried out at distances which are equal or less than a max- imum center-to-center distance of two adjacent radiators. A matrix of waveguides which are connected to at least one radiation source and made of fibre-optic waveguides having thinned ends or embodied in the form of micro-cones made of a material which is transparent for the used radiation is used as the radiator matrix. An emissive emitter matrix can also be used in the form of said radiator matrix. Said invention makes it possible to radically simplify a technological process for producing high-resolution images and used equipment.

EP 1 835 347 A1

**Description**

FIELD OF THE INVENTION

The invention relates generally to microlithography, in particular to photolithography and can be industrially realized for example in the fabrication of integrated circuits or structures having pre-programmed submicron topography.

BACKGROUND OF THE INVENTION

The creation of integrated circuits with characteristic line width of 0.1 - 0.01 micron is an important and promising direction in the development of up-to-date microelectronics. The high-precision technology (with submicron and micron tolerances) of making precision shapes with three-dimensional topography can find industrial application for example in mass production of microrobotic parts, high resolution elements in diffraction and Fresnel optics and in other technological areas where it is required to obtain three-dimensional image with pre-determined depth and high resolution structures in the functional layer of a device, for example in the production of printing plates used for making banknotes and other securities.

Further development of today's electronics depends to a great extent on the microlithography process resolution that defines the development level of the majority of current science and technology fields. Microlithography includes the process of coating the solid body surface (typically a substrate made of semiconductor material) with a layer of the material sensitive to used radiation flow, including electron beams where most frequently photoresist layer is used for this purpose. When photoresist is exposed through the so called photomask, usually called mask, this reproduces on photoresist an image or a pattern of pre-determined layout, for example the layout of integrated circuit.

There is known a method for generating a pattern on a material sensitive to used radiation where exposure spots are formed on the surface of the material sensitive to used radiation with the help of high-intensity short-wave radiation source and high - accuracy projection lens with big aperture that projects onto the surface of material sensitive to used radiation multiple pattern of positioned mask object (Presentation by Sunlin Chow on Intel Developers Forum San Jose, USA, September 2002).

There is known an apparatus for generating pattern on a material sensitive to used radiation where photoresist layer is used as this material, the apparatus is composed of high-intensity short-wave radiation source, mask object whose pattern is to be projected on the photoresist, mask object positioning units, high-accuracy lens with big aperture and transport device for relocating a substrate coated with photoresist onto which a multiple image of the positioned object is projected to make maximum use of the semiconductor substrate surface coated with light-sensitive material - photoresist (Presentation by Sunlin Chow on Intel Developers Forum San Jose, USA, September 2002).

The positioning accuracy in the best projection scanning systems (steppers) manufactured by the world leader in this area of the technological equipment for microelectronics, the Netherlands company ASM-Lithography, is 80 nm, which is evidently not sufficient for creating VLSI ICs with characteristic line width of 20-30 nm. The gap between steppers capabilities and industry demand is intrinsic because 3-5 years are required to develop stepper for submicron technologies, its cost in mass production is 10-15 million US dollars, nothing to say about the development cost amounting hundreds of millions US dollars.

Nowadays, photo-microlithography (or photolithography) is most widely used in the industry. This provides $\Delta x = k_1 \lambda / 2A$, where $\Delta x$ is the resolution determined by the wavelength of applied radiation $\lambda$ and projection system aperture A. Such dependence reasonably encouraged the developers to use shorter - and even shorter - wave radiation sources and larger- and even larger aperture projection systems. As the result within last 40 years industrial projection photolithography moved from mercury lamps with characteristic wavelengths of 330-400 nm to excimer lasers with wavelengths 193 and even 157 nm. Projection lens of modem steppers have up to 600-700 mm diameters (the need to increase the aperture A). All these factors determined the cost of steppers.

Unfortunately, the resolution is increased at the sake of decreased focus depth $\Delta F$, since $\Delta F = k_2 \lambda / A^2$, this consequently reduces the throughput and makes focusing system of giant projection lens very complicated, which again increases stepper cost. Moreover, side effects limit the use of such lens aperture for maximum resolutions provided by the lens.

In the process of projection photolithography development the minimum size of projected parts was decreasing at the average 30% each two years, which allowed each 18 months doubling the number of transistors in the integrated circuit (Moore's Law). At present 0.13 micron technology is used in the industry that allows printing parts with 100nm resolution, meantime, the next milestone according to experts' opinion would be projection systems and radiation sources ensuring reliable resolution at the level of 20-30 nm. This would require extreme ultraviolet sources (EUV) or even soft X-ray radiation. Nowadays there are intensive experiments with microlithography on $\lambda = 13.4$ nm. The first such prototype lithography tool was announced at Intel Developers Forum (Intel is the world leader in the production of VLSI ICs), in 2002 transistors with 50 nanometer lines were printed with this tool. However, the cost of such stepper even at volume production would be according to experts estimate around 60 million US dollars and this will require according to most optimistic estimates 5 -7 years to master mass production technology for microprocessors with characteristic 30 nm feature size.

One of the most critical constrains in photolithography is diffraction from mask edge (diffraction from screen edge) used for getting pre-defined projected image on photoresist surface. Due to this effect as we try to get the wavelengths of used radiation shorter the image quality degrades because of diffraction maximums located at λ distances from the center of designed line. As the leading manufacturers currently use wavelengths λ= 193 nm and even less (in experiments!) it becomes evident how significant is the resolution limit caused by edge diffraction on the mask.

Therefore, existing projection devices used to generate patterns on a light -sensitive layer have essential drawbacks:

1) significant difficulties of combining high resolution and focus depth in one device;
2) as the wavelengths become shorter the design and technology of projection devices used to project patterns onto photoresist surface become far more complicated;
3) as the wavelengths used for projection become shorter the optical system and technology of making mask object become extremely complicated;
4) as the scale integration in the products grows the equipment and technology becomes extremely expensive ;
5) extremely low technological flexibility in the fabrication process and very costly re-adjustment;
6) it is not possible in principle to make diversified manufacturing, i.e. fabrication of various integrated circuits on the same substrate with the same technological process

There is known a method for producing image on a material sensitive to used radiation, which is very close to proposed method options where exposure spots are created on the surface of material sensitive to used radiation by means of radiators array embodied as field emission array, the pre- defined image is produced by moving the material sensitive to used radiation in a plane parallel to the surface of radiation - sensitive material either in the same direction or in mutually perpendicular directions (WO 00/60632, published 12.10.2000).

There is known an apparatus for producing image on a material sensitive to radiation used, which is very close to proposed pattern generation device options and contains radiators array realized in the form of array of field emission array; meantime the apparatus is capable of generating pre-defined pattern by moving the material sensitive to radiation used in a plane parallel to the radiation - sensitive material (WO 00/60632, published 12.10.2000). However, in the known method and apparatus for producing pre-defined image on entire substrate surface it is necessary to move radiation sensitive material to significant distances, which makes the apparatus design very complicated, degrades pattern resolution and increases the time of pattern generation on photoresist. Besides, the known method and apparatus do not provide high pattern accuracy because the accuracy of exposure spots displacement over the surface of radiation - sensitive material is not adequate.

Essence of the Invention

The technical result that might be obtained due to realization of proposed invention is significantly simplified technological process of high resolution patterns generation on the material sensitive to radiation used and simplified design of the equipment used, as well as improved image resolution during pattern generation. Besides, the use of near-field optical waveguides or field emission emitters allow avoiding the constrains related to the use of masks with diffraction limit and go to the approach that allows generating high resolution patterns of two-dimensional and three- dimensional structures without masks and practically without any diffraction distortions, this also provides the capability of getting smooth line edge and changing the intervals (gaps) between pattern elements with accuracy up to 0.01 nm., the distance between the radiators and material sensitive to radiation used with discrete up to 0.01 nanometer; this allows firstly, getting necessary accuracy at 1-50 nanometer distances, thus providing the work in the near field practically without diffraction limit and secondly, getting pre-defined change in the exposure spot diameter depending on the distance to radiation- sensitive material and consequently getting exact size of pattern element, for example the line of a pre-determined width, displacement to radiation- sensitive material and /or radiators in direction perpendicular to this line and exposure spots overlay for getting the pattern in the form of continuous line or any other shape, for example two - dimensional figure. All these significantly reduce the cost of VLSIs development and simplify VLSI volume production. Elimination of masks allows diversification of fabrication process of VLSIs with various layouts on the same substrate. For example it is possible to make all PC VLSIs on the same substrate.

The said technical result has been achieved because in the first option of pattern generation method on the material sensitive to the radiation used, where exposure spots are formed on the surface of radiation- sensitive material by means of radiators, defined pattern is generated due to step movement of radiators and/or material sensitive to the radiation used in the plane parallel to the surface of radiation- sensitive material either in the same direction or in two mutually perpendicular directions; the radiators are formed as radiators array or composed radiation array composed of N radiator arrays; the sizes of radiators array or compose array are either equal to or exceed the size of pre-determined pattern generated on the material sensitive to radiation used, the diameter d of radiation flow at the output of each radiator is less than 100 nanometers; at the same time, radiator and/or radiation- sensitive material is displaced step-by-step at a pitch less than d to the distances not exceeding maximum distance between the axes of adjacent radiators.

It should be noted that the radiators located in the extreme rows of adjacent array pertaining to compose array also belong to adjacent radiators and the radiator's line of symmetry that usually coincides with the axis of radiation flow from the radiator is typically thought as radiator axis. Meantime, usually the distances between extreme axes of outermost radiator array or compose array in two mutually perpendicular directions coinciding with the direction of possible array or the radiation-sensitive material displacement movement are understood as the sizes of array or compose array. Besides, any array can be realized as two-dimensional array, i.e. in the form of array where the radiators are located in several rows, some radiators in each row.

In addition, the said technical result is achieved because in the first version of an apparatus for pattern generation on the material sensitive to the used radiation composed of radiators and substrate coated with radiation-sensitive material the apparatus is built with the capability of generating set pattern by displacing the radiators and/or the material sensitive to the used radiation in the plane parallel to the surface of radiation-sensitive material either in the same direction or in two mutually perpendicular directions, the radiators are formed as radiators array or composed radiation array composed of N radiator arrays; the sizes of radiators array or compose array are either equal to or exceed the size of set pattern generated on the material sensitive to radiation used, and diameter d of radiation flow at the output of each radiator is less than 100 nanometers; at the same time, radiator and/or radiation-sensitive material are set in a way that allows movement at the pitch less than d to the distances not exceeding maximum distance between the axes of adjacent radiators.

In the first option of the method and the first version of the apparatus in order to increase the accuracy of generated pattern the step movement is reasonably performed with the pitch from 0.01 nm to 1 nm, while the diameter d of radiation flow at the output of each radiator may be in the range from 10 nm to 50 nm. However, in this case the pitch may be larger, provided the set pattern accuracy permits; this allows reducing pattern generation time. Generally, when generating continuous pattern the pitch is determined by required exposure spots overlay because the overlay affects the accuracy of continuous pattern edge or the line, and its "corrugation". To enable pattern generation on the sensitive material with proposed apparatus it is necessary to control the radiation flow from each radiator and /or movement pitch.

Besides, in the first method and apparatus options target sizes of exposure sports on the surface of the material sensitive to used radiation can be obtained by setting radiator array or compose array at defined distance z from the surface of radiation-sensitive material by step motion of radiators and/or the material sensitive to the used radiation at a pitch less than d. The proven movement pitch for better exposure spots accuracy is in the range from 0.01 nm to 1 nm. The radiators and/or radiation-sensitive material move in the direction perpendicular to the surface of radiation-sensitive material up to defined overlay formed by adjacent exposure spots radiators.

The distance z between radiator array and material sensitive to used radiation is in the range from 1 to 5000 nm, meantime, in order to work in the near-field the distance z should be from 1nm to d. In the first method and apparatus options light-emitting element array where the light-emitting elements are connected to at least one radiation source and are made of optical waveguides with thinned ends coated with the radiation reflective layer can be used as each radiator array; as the diameter of thinned optical waveguides is equal to the flow diameter d, the diameters of thinned optical waveguides in the direction of the material sensitive to used radiation are less 100nm, preferably from 10nm to 50 nm.

These thinned optical waveguides can be made by a known technique described for example in the article (E.Betzig, J.K.Trautman al., Science, 251, p. 1468, 1991) whose authors were the first to coat the outer surface of thinned optical waveguides with radiation reflective layer, thus creating a near-field optical waveguide.

Besides, light-emitting element array where the light-emitting elements are connected to at least one radiation source and realized as microcones made of the material transparent for used radiation and being near-field optical waveguides can be used as each radiator array; the microcones are coated with the layer reflecting the radiation; the radius of rounding at microcones top directed to the material sensitive to used radiation is half of the diameter d of the radiation flow at the output of each radiator, in connection with that the radius of rounding at microcones top is less than 50nm, preferably from 5 to 25nm. The microcones can be made of semiconductor material, for example, silicon or compounds like $A_{III}B_V$ or $A_{II}B_{VI}$ coated with aluminum layer reflecting the passing radiation. These microcone arrays are produced with conventional technology used in chip manufacturing (Yu. D. Chistyakov, Yu. P. Rainova, Physical and Chemical Fundamentals of Microelectronic Technology, Moscow, 1979. E.I. Givargizov Whiskers and Plate Chips Vapor Deposition, Science, GIFMML, Moscow, 1977).

With technologies available in modem microelectronics it is possible to make on their base solid state nanolasers and light-emitting diodes producing radiation with defined wavelengths or individually switched gate devices regulating radiation entry to the microcone. (Charles Lieber, CERN Courier, May 2003).

At the same time, each optical waveguide made either with thinned end or as micro cone can be connected to a separate radiation source capable of controlling radiation intensity. Besides, the optical waveguides can be grouped, each group is connected to its own radiation source, still between the radiation source and each optical waveguide there is a controlled modulator or gate device capable of controlling the radiation intensity from respective optical waveguide.

Both in the method and apparatus microcones made of dielectric or semiconductor material can be formed on the surface of planar optical waveguide transparent for defined radiation and on the basis of these microcones individually switched gate devices regulating radiation entry to the microcones can be built.

Apart from this the array of field emission emitters connected to at least one power supply unit can be used as a radiator array. The best results are achieved when field emission emitters array and the material sensitive to the used radiation are located in the magnetic field formed over longitudinal axes of field emission emitters, in this case under the influence of uniform axial (with respect to the beam) magnetic field it is possible to eliminate divergence of electronic beams emitted by their nib and dramatically improve the resolution resulting from such beam interaction with radiation-sensitive material. The field emission emitters in a permanent magnetic field can be placed at significantly larger distance from the substrate with radiation - sensitive material. The distance z between radiators array and the material sensitive to used radiation should not exceed the distance at which the magnetic field creates larmor radius of emitted electron bunch on the surface of radiation-sensitive material not exceeding the set exposure spot radius on the surface of radiation - sensitive material. Then due to field emission emitters arrangement in the magnetic field they all can be placed at a distance z exceeding several millimeters from the surface of radiation-sensitive material. However, if required field emission emitters can be placed at shorter distance, for example 1- 5000 nanometers from the surface of the material sensitive to used radiation.

Both in the method and apparatus in order to move sensitive material and/or array or compose array various drivers and the combination thereof are used. The apparatus can be also realized with the capability of moving the radiators formed as array or compose radiator array and/or the material sensitive to used radiation in three mutually perpendicular directions. It is reasonable to position the material sensitive to used radiation (photoresist), array or compose array with precision XYZ - nanopositioner. The substrate with radiation-sensitive material or radiators can be made by XYZ-nanopositioner. However, it is most reasonable to connect the substrate with sensitive material to the first XYZ-nanopositioner and array or compose array of the radiator to the second XYZ-nanopositioner. In this case it is possible to form the required layout during photoresist exposure by moving radiator array or compose array and the material sensitive to used radiation towards each other.

Apart from this, the said technical result is achieved because in the second version of the apparatus for pattern generation on the material sensitive to the used radiation containing radiators and substrate coated with radiation-sensitive material the apparatus is built with the capability of generating defined pattern by displacement of radiators and/or the material sensitive to the used radiation towards each other, the radiators are made in the form of at least one radiation source connected to at least one optical waveguide embodied as fiber optics with thinned ends or shaped like microcones of the material transparent for used radiation; at the same time the diameter d of radiation flow at the output of each radiator is less than 100 nm, and radiators and/or the substrate with sensitive material are set in such a way that allows their movement towards each other with the pitch less than d.

The diameters of fiber optic waveguides thinned ends or radius of rounding at the vertex of microcones directed to the material sensitive to used radiation is in the range from 10 to 50 nanometers seem to be the most appropriate.

In order to move the waveguides or the substrate with the material sensitive to used radiation the ZYZ-nanopositioner with 0.01 nm pitch can be introduced. In this case the distance z between the waveguides and the material sensitive to used radiation is in the range from 1 to 2000 nm. However in order to get the resolution $\Delta x \approx d$ the distance between the waveguides and radiation- sensitive material may not exceed d. In order to generate the defined pattern the apparatus has the capability to control the radiation coming from the waveguides, for example switching it by radiation sources control or the gates use. If the waveguides are created in the form of silicon microcones or the compounds like $A_{III}B_V$ or $A_{11}B_{V1}$ solid state switch nanolasers and light emitting diodes generating defined radiation or individually switching gate devices regulating radiation entry to microcones can be created on their base. Besides, microcones can be located on respective planar optical waveguides. In order to increase the throughput the waveguides can be realized as at least one two-dimensional multi row array with some waveguides in each row or the compose array with several waveguide arrays. The size of waveguides array or N waveguide arrays can be equal to or exceed the size of the pattern on the materials sensitive to used radiation and radiators and/or the substrate with the material sensitive to used radiation can be set in a way allowing the motion to a distance not exceeding the maximum distance between the axes of adjacent radiators. Moreover, the apparatus may be capable of changing the motion pitch depending on the required pattern accuracy and the time of its generation.

Besides, the said technical result is achieved because in the third version of the apparatus for pattern generation on the material sensitive to the used radiation containing at least one radiator performed in the form of field emission emitter connected to power supply, the substrate with the material sensitive to used radiation and magnetic field source;

the substrate with the material sensitive to used radiation and /or at least one field emission emitter is placed in a way allowing the motion relative to each other, the substrate with the material sensitive to used radiation and all field emission emitters are located in the magnetic field in the direction along direct axis of each field emission emitter spike; the diameter d of radiation flow at the output of each field emission emitter is less than 100 nm, in addition the field emission emitters and/or the substrate with the material sensitive to used radiation are set with the capability of moving relative to each other with the pitch less than d.

In order to move the field emission emitters or the substrate with the material sensitive to used radiation XYZ-nanopositioner with 0.01 nm pitch can be installed. The most appropriate diameter d for the radiation flow at the output of each field emission emitter is in the range from 10 to 50 nm, and the distance z between field emission emitters and the material sensitive to the used radiation should not exceed the distance at which the obtained magnetic field creates larmor radius of emitted electron bunch on the surface of the material sensitive to used radiation not exceeding the set exposure spot radius on the surface of radiation - sensitive material. Then due to field emission emitters arrangement in the magnetic field they all can be placed at a distance z exceeding several millimeters from the surface of the material sensitive to the used radiation. However, if required field emission emitters can be placed at shorter distance, for example 1- 5000 nanometers from the surface of the material sensitive to used radiation.

In order to generate the defined pattern the apparatus has the capability of controlling the electronic bunch intensity from the field emission emitters, for example by switching it and controlling the emitted current

In order to increase the throughput the field emission emitters can be realized as at least one two-dimensional multi row array with some field emission emitters in each row or the compose array containing N field emission emitter arrays. The size of the array or N arrays can be equal to or exceed the size of the pattern on the materials sensitive to used radiation and radiators and/or the substrate with the radiation -sensitive material can be set in a way allowing the motion to a distance not exceeding the maximum distance between the axes of adjacent radiators. At the same time, the apparatus can have the capability of changing the pitch size depending on the required accuracy of generated pattern and the generation time.

When we speak about the "radiation" in relation to field emission emitter electrons it should be evidently explained that according to corpuscular wave dualism the bunch of electrons is equivalent to the plane wave and electron (depending on energy) can be characterized by respective de Broglier wavelength.

Apart from this the said technical result is achieved because in the second option of the method of generating the pattern on the material sensitive to used radiation where on the surface of the material sensitive to used radiation exposure spots are formed by means of the radiators and the set pattern is generated by step motion of the radiators and/or the material sensitive to used radiation in the plane parallel to the surface of radiation- sensitive material either in the same direction or in two mutually perpendicular directions; the radiators are formed as radiator array or composed radiation array including N radiator arrays; the diameter d of radiation flow at the output of each radiator is less than 100 nm; the radiators and/or the material sensitive to used radiation continuously move step - by -step at a pitch less than d; the time of each pulse coming out of each radiator is controlled in such a way that within the time of the pulse from at least one radiator having the shortest duration the relative displacement of radiators and the material sensitive to used radiation does not exceed the set value.

Besides, the said technical result is achieved because in the fourth version of the apparatus for pattern generation on the material sensitive to the used radiation containing radiators and substrate coated with the material sensitive to used radiation the apparatus is capable of generating set pattern by moving the radiators and/or the material sensitive to the used radiation in the plane parallel to the surface of the material sensitive to used radiation either in the same direction or in two mutually perpendicular directions; the radiators are formed as radiator array or composed of radiation array including N radiator arrays; the diameter d of radiation flow at the output of each radiator is less than 100 nm; the radiators and/or the material sensitive to used radiation are set in such a way that allows their continuous step movement at a pitch less than d; the apparatus has the capability of controlling the time of each pulse coming out of each radiator so that within the time of the pulse from at least one radiator having the shortest duration the relative displacement of radiators and the material sensitive to used radiation does not exceed the set value.

Both in the second option of the method and in the apparatus of its realization in order to achieve the set accuracy within the pulse time coming out of at least one radiator and having the shortest duration the relative displacement value $\Delta S$ in the radiators and the material sensitive to used radiation should not exceed $0,01d_1$ where $d_1$ the diameter of exposure spot when the radiators and the material sensitive to used radiation are stationery.

At the same time, in all above said method options and apparatus versions the sizes of the radiator array or compose array can be equal or exceed the size of set pattern generated on the material sensitive to used radiation; and the radiators and/or the material sensitive to used radiation can continuously move step - by - step to the distances not exceeding maximum distance between the axes of adjacent radiators. Besides, the appropriate pitch for step motion is in the range from 0.01 nm to 1 nm, and the diameter d of the radiation flow at the output of each radiator is from 10 to 50 nanometers.

The apparatus is capable of changing the pitch depending on the required pattern accuracy and pattern generation time.

Besides the required size of exposure spots on the surface of the material sensitive to used radiation can be achieved by setting the radiators at defined distance z from the surface of the material sensitive to used radiation by step movement of radiators and/or the material sensitive to used radiation in the direction perpendicular to the surface of sensitive material at a pitch less than d. The best accuracy of the exposure spots is achieved at the motion with a pitch from 0.01 to 1 nanometer. At that the radiators and/or the material sensitive to the used radiation can move in the direction perpendicular to the surface of the material sensitive to used radiation up to defined overlay formed by the adjacent exposure spot radiators.

The distance z between radiator array and the material sensitive to used radiation may be from 1 to 5000 nm, and for the work in the near-field the distance z may be from 1nm to d.

As in the above described method and apparatus versions the array of waveguides connected to at least one radiator source and made of fiber optics with thinned ends coated with radiation reflective layer can be used as each radiator array, then the diameters of thinned optical waveguides directed to the material sensitive to used radiation are less than 100 nm and preferably from 10nm to 50 nm.

Besides, the array of optical waveguides connected to at least one radiator source and shaped like microcones of the material transparent for used radiation being the near-field waveguides can be used as radiator array; the microcones are coated with the layer reflecting the radiation; the radiuses of rounding at the vertex of cone are less that 50 nm, preferably 5-25 nm.

The microcones can be made of semiconductor material, for example silicon or the compounds like $A_{III}B_V$ or $A_{II}B_{VI}$, coated with the layer reflecting the passing radiation. The solid state nanolasers and light emitting diodes generating radiation with defined wavelength or individually switching gate devices regulating radiation entry to microcones can be created on their base.

Each waveguide made either as the waveguide with thinned end or a micro cone can be connected to a separate radiation source capable of controlling radiation intensity. The waveguides can be grouped, each group is connected to its own radiation source, and controlled modulator or gate device capable of controlling the radiation intensity from each waveguide are put between the radiation source and each waveguide. It is also possible to connect all waveguides to one radiation source, then controlled modulator or gate device capable of controlling the radiation intensity from each waveguide are also introduced between the radiation source and each waveguide. Besides, microcones made of dielectric or semiconductor material can be generated on the surface of planar waveguide transparent for set radiation, in this case on the basis of the cones there can be made individually switching gate devices, regulating radiation entrance to microcones.

Apart from this the array of field emission emitters connected to at least one power supply can be used as each radiator array. The best result is achieved when field emission emitter array and the material sensitive to used radiation are placed in the magnetic field directed over longitudinal axes of field emission emitters. Then the distance z between radiator array and the material sensitive to used radiation should not exceed the distance at which produced magnetic field provides larmor radius of emitted electron bunch on the surface of the material sensitive to used radiation not exceeding the set exposure spot radius on the surface of radiation - sensitive material. Then due to field emission emitters arrangement in the magnetic field they all can be placed at a distance z exceeding several millimeters from the surface of the material sensitive to the used radiation. However, if required field emission emitters can be placed at shorter distance, for example 1- 5000 nanometers from the surface of the material sensitive to used radiation.

The apparatus is capable of moving the radiators formed as array or compose radiator array and/or the material sensitive to used radiation in three mutually perpendicular directions. It is reasonable to position the material sensitive to used radiation (photoresist), array or compose array with precision XYZ - nanopositioner. The substrate with sensitive material or radiators can be provided with XYZ-nanopositioner. However it is most reasonable to connect the substrate coated by sensitive material to the first XYZ-nanopositioner and array or compose array of the radiator to the second XYZ-nanopositioner. In this case it is possible to form the required layout during photoresist exposure by moving radiator array or compose array and the material sensitive to used radiation towards each other.

Short description of the drawings

Fig.1 shows the apparatus version for generating pattern on the material sensitive to used radiation with the array made of optical waveguides in the form of microcones.

Fig. 2 shows the apparatus version for generating pattern on the material sensitive to used radiation with the array made of field emission emitters.

Prefered embodiments of the invention.

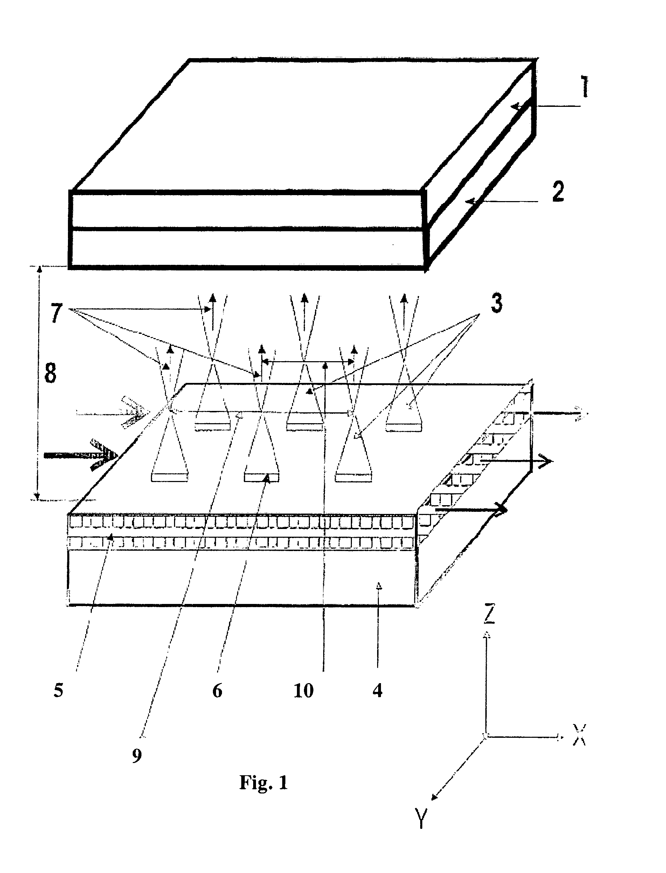

The apparatus (Fig. 1) for generating pattern on the material sensitive to used radiation, for example photoresist, includes the substrate 1 with photoresist layer coated thereon 2 and radiators array 3 located on a planar optical waveguide 5 and mounted on a unit 4 schematically shown on Fig.1 designed for array mounting and moving. The radiator array shown in Fig.1 as an example is realized as an array of waveguides connected to the source or sources of radiation (not shown). The waveguides are made as microcones of dielectric or semiconductor material transparent for used radiation and are coated with the layer reflecting this radiation; actually they are the near-field optical waveguides. They are located on the surface of planar waveguide 5, bringing radiation to the basis of near-field waveguides being microcones.

On the basis of microcones individually switched devices 6 realized for example as the gates regulating radiation entrance to microcones may be placed. In case the waveguides are made as optic fiber waveguides with thinned ends individual switching devices (gates) are placed between the radiation source and input of respective waveguide.

The radiation sources can be made as nanolasers or light emitting diodes generating radiation of set wavelength and located at microcones base. On Fig.1 according to the most preferable realization of drive systems radiator array 3 is set in a way allowing the movement in three mutually perpendicular directions XYZ (on Fig. 1 shown by arrows). The pitch and number of steps in plane XY parallel to photoresist surface are determined by required resolution for particular pattern. When the movement is in Z direction perpendicular to photoresist surface the pitch is determined by:

1) desired size of exposure spot, i.e. divergence of radiation bunch/bunches 7 exposed/exposing photoresist 2, and
2) the accuracy of exposure spot/spots dependant on the distance 8 between radiator source array and photoresist.

As the sizes of waveguides bases (microcones) in XY plane can significantly exceed the size of exposure spots produced by these waveguides the continuous (full) exposure producing for example full line is achieved by moving waveguides array to the distance necessary to generate required pattern. In case the array on each of XY axis has the size 9 equal to or a little bit larger than the size of generated pattern in order to obtain such pattern the array should be moved only to the distance of maximum distance 10 between the axes of adjacent spikes also called whiskers (microcones) along each axes in XY plane (on Fig. 1 this distance is shown only in X-direction).

The waveguides can form two-dimensional array with several rows, several waveguides in each row (Fig.1); the array size is determined by the distances 9 between the axes of extreme outermost waveguides along X and Y axes (on Fig. 1 only array size in X-direction is shown).

The waveguides can be grouped as a number of two-dimensional arrays located in several rows having some arrays in each row; meantime, each array consists of a number of waveguide rows with several waveguides in each row. It is reasonable to have the same position step for radiators, i.e. the distance between the axes of adjacent radiators in each mutually perpendicular direction; however, it can be also different. In addition, the said step at least in one of the arrays included into compose array can differ from the radiator step in any other array. In this case such compose array has total (cumulative) size 9 along each axis in XY plane equal or a little bit larger that the set pattern size or entire substrate with photoresist along each axis in XY plane, then in order to achieve desired photoresist exposure such array can be shifted along each axis in XY plane to the distance not exceeding maximum distance 10 between the axes of adjacent waveguides (microcones) along each of the axes within the limits of this compose array. The pitch of each motion during photoresist exposure is determined by adjacent exposure spots overlay degree whereas the size of exposure spot is determined (at set resolution whose value depends on the parameters of near-field waveguide being, the micro cone in this case) by the distance from the photoresist surface to the vertex of the waveguide and by the convergence of such near-field radiation bunch. By means of switching separate waveguides it is possible to form on light-sensitive layer (photoresist) located in the immediate vicinity to the array the pattern of required layout.

When ideal point radiation source located at a distance less than characteristic size d of the near-field waveguide is used the light spot (exposure spot) is produced on the photoresist surface. In this case the diffraction maximums do not appear on the edge of exposure spot. Such ideal point source can be represented by a radiator made for example as thinned waveguide pulled from glass fiber in such a way that at its end the waveguide diameter will be around 10 nm, or as micro cone with the radius of rounding at its vertex of 5 nm. However, it is known that the diameter of exposure spot at a distance $z \approx d$ (where d is the diameter of the waveguide end) will be also close to d. Therefore, when using the array of such waveguides arranged in a way that allows creating exposure spots on the surface of photoresist or any other material sensitive to used radiation, these exposure spots being actually formed by ideal point sources, it is possible to produce flat image on photoresist at $z \approx d$ distance. By switching separate waveguide arrays it is possible to form the rows of photo lines or a family of variously arranged photo points whose shapes repeat the shapes of exposure spots created by near-field waveguide array.

If the radiation source emitting required wavelength or gate device through which the radiation passes are placed at the end of each waveguide it becomes possible to create any flat image with the resolution $\Delta x \approx d$ on the surface of light-sensitive layer (photoresist) located at a distance d by switching above mentioned sources or gate devices. Both radiation source and fast gates at the ends of waveguides to which photoresist exposing radiation arrives can be switched in this way.

To provide minimum number of motion steps and thus increase the pattern generation time the distances between radiator axes should be minimal. However, distance reduction is limited by possible radiator sizes, namely by outer diameter of not thinned part of fiber-optic waveguides, diameter of waveguides bases in the form of microcones in the place of their contact (junction) with substrate or planar waveguide, size of field emission emitters vertex bases etc. The existing technology of manufacturing said radiators allows minimum size of not thinned part of fiber-optic waveguides' outer diameter around -10-20 micron, minimum diameter of waveguides bases in the form of microcones around - 1-3 micron and minimum size (diameter) of field emission emitters vertex bases around - 1-3 micron. All these sizes significantly exceed desired diameter of radiation flow at radiators output required to provide set resolution, this necessitates the step radiators motion at a pitch evidently less and not exceeding the distance between the axes of adjacent radiators.

In connection with that both the near-field waveguides and field emission emitters can be arranged in such a way that exposure spots on photoresist surface form flat image of defined shape including both separate exposure spots and their groups. In addition, during photoresist exposure the required layout is obtained by means of successive positioning of the substrate with photoresist under the array or compose array in the process of controlled motion performed with precision XYZ-nanopositioner that allows photoresist positioning with minimal pitch down to 0.01 nm. The radiators and array precision positioning are switched with linear resolution significantly exceeding the resolution achieved by radiators arrangement in the array being equal to characteristic size d. The size of exposure spot generated by each radiator allows exposing on photoresist surface any defined layout determined by the characteristic size of exposure spot. It is important to note that in this case the positioning is done within the motion of precision nanopositioner step because the distance between radiator axes providing the exposure may be around 1-100 micron. Here any precision positioner with adequate resolution of ($\Delta x$, $\Delta y < d$) and necessary motion base exceeding maximum distance between adjacent radiator axes can be used. In case the array consists of N arrays, where N is equal to the number of VLSI ICs on a silicon wafer, the distance between the VLSI layout projections on photoresist is a fortiori larger than the maximum shift of a single array during exposition forming the defined layout of a single VLSI on photoresist, this is done to avoid the situation when one VLSI is overlapping the other VLSI during the shift of a single array that writes this VLSI.. All the VLSIs produced can be similar, however, it is also possible to make different VLSIs by regulation of each separate radiation source in each array. This is true for the VLSI having both various layout s and various sizes.

By switching each radiator in each array within the compose array whose size is more than or equal to silicon or any other substrate and due to precision motion to the distance not exceeding maximum distance between adjacent radiators axes with a pitch that allows making the exposition layout with resolution determined by characteristic size of exposure spot and set overlay it is possible during exposition of one such substrate to create on this substrate VLSIs with different layouts; this creates inestimable advantage for the design and fabrication of custom integrated circuits and dramatically decreases the cost of designing new VLSI..

Proposed apparatuses built with precision XYZ- nanopositioners can substitute the steppers. Such apparatuses allow making parallel exposition of entire substrate thus significantly increasing the throughput. According to preliminary estimate the cost of such apparatus in volume production might appear 40 or 50 times les than the cost of known steppers. This might be a weighty argument in favor of creating and using the apparatuses of this type as the cost of modem steppers reaches 20 million US dollars and more.

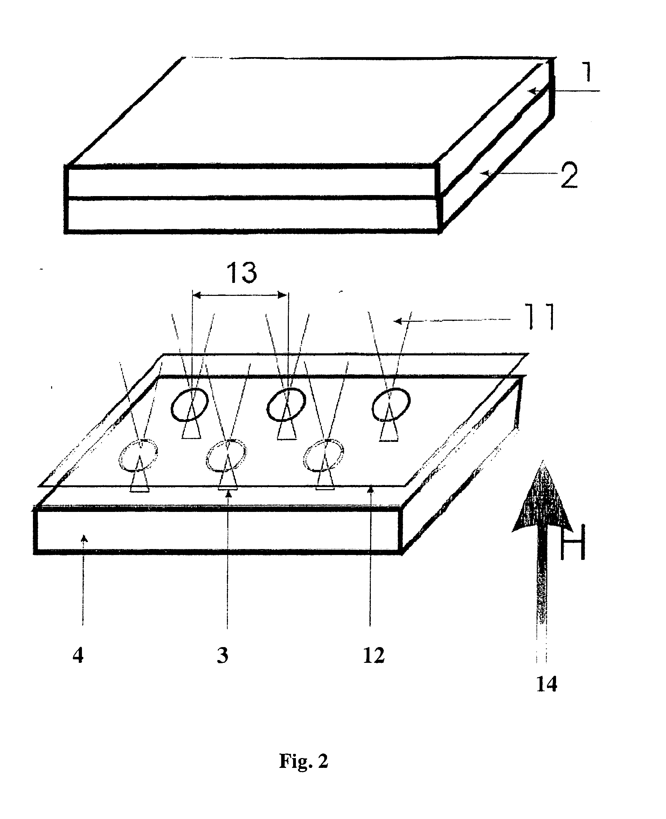

The natural development of proposed photolithography technology is the use of auto-emitting spiking arrays, i.e. the arrays of field emission emitters. Fig.2 shows one of the versions of apparatus design where radiator array 3 is made in the form of field emission emitters located on the substrate 4 and emitting electronic bunches 11 under the effect of sweeping diaphragm field 12. These bunches generate exposure spots on photoresist 2 coated onto the substrate 1 made of semiconductor material. The use of field emission multi-spiking arrays ensures the move from low-output electronic lithography where the scanning electronic beam moves step-by-step and creates the defined layout on adequate photoresist to multi-bunch planar electronic lithography with drastic throughput increase.

The use of field emission spiking arrays with individually controlled pikes provides the following capabilities:

1) to perform parallel high-efficient photoresist exposure with extremely high spatial resolution;

2) in case the exposure spots formed by some pikes are not overlapped the shift of field emission array to the distances not exceeding maximum distances 13 between the axes of adjacent pikes (as in the case with waveguide array) allows (if required) continuous exposure in the limits of photoresist area. In addition when axial (relative to emitters axes and emitted electron bunches) magnetic field 14 is used, the distortion appearing when the electronic bunch deviates to angles different from paraxial is completely eliminated;

3) when the pikes are switched together with field emission array shift it is possible to generate any pattern on photoresist surface within the exposure area.

The proposed method and apparatus along with significant throughput increase allow making various VLSI on the same substrate at the same time. Generally it is possible to make all VLSIs available for example in PC or other device on the same substrate. The use of multi-spiking arrays provides extremely high resolution patterns on photoresist with much higher throughput than conventional electronic lithography; besides, this allows eliminating practically all distortions and difficulties at achieving high resolution full line patterns due to the capability of controlling with high accuracy the shift of photoresist and field emission array relative to each other.

At the same time, the use of axial (relative to spikes) magnetic field 14 eliminates the divergence of electronic bunches emitted by each spike and provides significantly better resolution achieved when such bunch interacts with photoresist. The distance from field emission emitters' vertexes (spikes) to photoresist surface may reach tens of millimeters without loss of resolution and intensity under effect of respective magnetic field. Moreover, any limitations related to the Depth of Focus (DOF) are eliminated.

It should be outlined that the material sensitive to used radiation can be exposed during step motion with controlled radiation at the output of each radiator; radiation pulses are formed at static position of radiators and the material sensitive to used radiation after each next motion step. In this case pulse duration is determined by radiation intensity at the output of each radiator and by the distance from radiator to the material sensitive to used radiation.

However, in principle there is no need to use exposure when the radiators and the material sensitive to used radiation are static. This is also possible to expose photoresist during continuous movement of a substrate with photoresist and the array.

In order to prevent remarkable increase of exposure spot diameter on photoresist resulting from such movement exposure pulse duration should be pretty small; within the exposure pulse time relative shift of $\Delta S$ array and the substrate should not exceed pre0defined value determined by accuracy of generated image, for example $\Delta d_1 \leq 0,01d_1$ where $d_1$ is exposure spot diameter when the radiators and the material sensitive to used radiation are static.

For this purpose the time of radiation pulses from each radiator is controlled. Then it is evident that in general case the pattern stretched along movement direction, for example a line, can be generated both by continuous sequence of short pulses and by one long time pulse, i.e. the time of radiation pulse coming out of different radiators can differ. There fore it is important to ensure that the value of relative $\Delta S$ radiators shift and the material sensitive to used radiation within the time of radiation pulse from at least one radiator with the shortest duration does not exceed pre-defined value, for example $0,01d_1$. In connection with that it is preferable to use exposure technique providing step movement at a pitch from 0,01 to 1 nm and radiation flow diameter d at the output of each radiator from 10 to 50 nm.

The quantitative analysis of this proposal realization is given below.

In case diameter d of radiation flow from each radiator is 10 nm and the distance z from radiators to the material sensitive to used radiation complies with the conditions of near-field effect, the diameter of a single exposure spot $d_1$ is also around 10 nm.

The radiation intensity required for photoresist exposure in a single spot can be estimated on the basis of the data taken from conventional lithography. As it takes 36 seconds to exposure 300 mm silicon substrate (the best steppers throughput is 100 substrates per hour, radiation source power being 100W) the area with 10 nm diameter has about $4 \cdot 10^{-12}$J.

In this case if the pulse time is $t_{imp}=10^{-7}$ s and the radiators are made as optic fiber waveguides with thinned ends coated with radiation reflecting material connected to at least one radiation source, in particular laser, the power of the laser on the opposite to thinned waveguide end should be around $4.10^{-2}$W taking into account the fact the radiation is less in the narrowed waveguide end, at least $10^3$ times less.

Besides, power saving factor should be accounted for because only some parts of photoresist are exposed, and not the entire mask, including those mask areas that absorb falling radiation as it happens even 13,4 nm lithography. This might to all appearance make the requirements to radiation source power at least 2-3 times less. It should be noted that reduction of light source wavelength will dramatically (10-20 times) reduces degradation of radiation intensity coming to photoresist surface. Besides, as the experiment shows (Appl.Phys.Let. 73, #15, pp.2090-2092, 12th October 1998) the use of near field waveguides with three step, narrowed cones allow increasing the capacity of such waveguide more than 1000 times. Thus there is a big reserve for further capacity increase. When the allowed difference in a single exposure spot diameter $d_1$ during exposure time $t_{imp}$ is not more than 1%, i.e. $\Delta d_1 \leq 10^{-1}$nm, the substrate maximum average movement speed **V** relative to waveguide array can be determined from the following proportion:

$$\mathbf{V} = \frac{\Delta d_1}{t_{imp}} = \frac{10^{-1} \cdot 10^{-3}}{10^{-7}} = 10^3 \text{ um/s}$$

Then, due to the thickness of non thinned waveguide part the distance between the axes of adjacent thinned waveguides ends $l_1$ can be 0.1 -20 um, therefore assuming $l_1$ = 10 um, then in order to fill one element of exposure surface being a square with the side $l_1$ and the area $10^2$ um with exposure sports of 0.01 um diameter, located at a pitch 0.01 um, it is necessary to have M radiation pulses during the shift over X and Y axes:

$$M = \frac{4 \cdot 10^2}{\pi \left(10^{-2}\right)^2} = 1{,}27 \cdot 10^6$$

Thus, if the pulse time is $10^{-7}$s, then the full exposure time for one element on a substrate whose (element) sizes are determined by the distances between the axes of adjacent waveguides over X and Y will be

$$t_{exp} = t_{imp} \cdot N = 10^{-7} \cdot 1{,}27 \cdot 10^6 = 0{,}127 \text{ c}$$

In this case if the size of radiators array is equal to or more than the size of pre defined pattern on the material sensitive to used radiation, then the time obtained is equal to entire substrate exposure time.

Besides, taking into account that both the substrate and the array can move simultaneously and linear sizes of the array are more than linear sizes of exposure area, i.e. the size of the pattern to the value around $2l_1$, then the exposure time for one substrate will be the largest value among other values such as exposure time $t_{exp}$ and the time of substrate travel relative to array $t_{travel}$.

At the same time, the substrate to array travel time $t_{trevel}$ to the distance equal to linear size $l_1$ of exposure surface element size can be determined as follows:

$$t_{trevel} = l_1/V = 10/10^3 = 10^{-2} s,$$

i.e.. $t_{trevel} \ll t_{exp}$.

In fact, assuming that it takes 36 s to expose one 300 mm silicon substrate the exposure throughput in case of array technology defined by $t_{exp}$ appears to be 284 times bigger than the throughput in a conventional stepper, because this is exactly the ratio of effective exposure time for stepper and array technology.

Finally, it should be noted that significant advantage in terms of throughout can be achieved when the scale integration (i.e. specific density of elements arrangement on the surface of silicon substrate) increases by 169 times [$(130/10)^2$] as exactly to this number (comparing to available now 130 nm technology) the characteristic size of the area occupied by each element on a substrate is decreased when exposure is performed with near field waveguides, which is not a trivial case. Actually, the throughput is defined by exposure power, i.e. the pulse time $t_{imp}$ that determines allowed array travel speed V, wavelength $\lambda$ defining the real array transmission coefficient and consequently by the power of exposure source as well as photoresist sensitivity - necessary radiation dose.

All above mentioned reasons related to the use of continuous step movement refer as well to the radiators composed of waveguides in the form of microcones or field emission emitters. Significantly less cost of the tools like array cassette allows raise the question about the creation of conveyer microchip production, i.e. the cassette of this type can be introduced into technological flow after each process. The benefit of using continuous chip fabrication may be very significant.

Thus the creation and use of proposed waveguides and field emission array devices in proposed methods radically simplify the technology allowing transition from industrial era in VLSI manufacturing to post industrial manufacturing technology when VLSI design and production could be made by small groups, i.e. when such technology becomes available not only to giant modem plants 2-4 billion US dollars worth, but to numerous small groups of scientists and engineers.

**Claims**

1. A method of pattern generation on the material sensitive to used radiation on which exposure spots are formed on the surface of radiation-sensitive material by means of radiators; the pre-determined pattern is generated by step movement of radiators and/or radiation - sensitive material in a plane parallel to the surface of radiation-sensitive material either in the same direction or in two mutually perpendicular directions, wherein the radiators are composed as radiators array or compose radiators array including N radiator arrays; the size of radiators array or compose array is either equal to or more than the size of pre-determined image on the material sensitive to used radiation, and diameter d of radiation flow from each radiator is less than 100 nm; the pre-determined pattern is generated by step movement of the array or compose array and /or the material sensitive to used radiation in the plane parallel to radiation-sensitive material at a pitch less than d to the distances not exceeding maximum distance between the axes of adjacent radiators.

2. The method according to i.1, **wherein** step movement is performed at a pitch from 0.01 nm to 1 nm.

3. The method according to i.1, **wherein** diameter d of radiation flow from each radiator is from 10 nm to 50 nm.

4. The method according to 1.1, **wherein** the radiation flow from each radiator is controlled for the purpose of generating pre-determined pattern.

5. The method according to i.1, wherein the required sizes of exposure spots on the surface of the material sensitive to used radiation are provided by placing radiator array or compose array at pre-defined distance z from the surface of the material sensitive to used radiation by means of step movement of radiator array and /or the material sensitive to used radiation in the direction perpendicular to the surface of the material sensitive to used radiation at a pitch less than d.

6. The method according to i.5, wherein step movement is performed at a pitch from 0.01 nm to 1 nm.

7. The method according to i.5, wherein radiators and /or the material sensitive to used radiation move in the direction perpendicular to the surface of the material sensitive to used radiation till the pre-determined overlay formed by adjacent radiators exposure spots is reached.

8. The method according to i.5, wherein the distance z between the radiators array and the material sensitive to used radiation is from 1 nm to 5000 nm.

9. The method according to i.5, wherein the distance z between the radiators array and the material sensitive to used radiation is from 1 nm to d.

10. The method as in any of items 1-9, wherein array of waveguides connected to at least one radiation source made of fiber optic waveguides with thinned ends coated with radiation reflecting layer are used as a radiator array.

11. The method as in any of items 1-9, wherein any of radiator array is represented as an array of waveguides connected to at least one radiation source and shaped as microcones made of the material transparent to used radiation, wherein the radius of rounding at microcones vertex directed towards the material sensitive to used radiation is equal to half of radiation flow diameter d from each radiator, wherein the microcones are coated with the layer reflecting the passing radiation.

12. The method as in any of items 1-7, wherein the array of field emission emitters connected to at least one current source is used as any of radiators array, and the field emission emitters and the radiation - sensitive material are placed in magnetic field formed along longitudinal axes of field emission emitters.

13. The method according to i.12, **wherein** the distance z between the radiators array and the material sensitive to used radiation does not exceed the distance at which formed magnetic field provides larmor radius of emitted electron bunch on the surface of material sensitive to used radiation not exceeding pre-determined exposure spot radius on the surface of the radiation-sensitive material.

14. An apparatus for pattern generation on the material sensitive to used radiation composed of radiators and the substrate sensitive to used radiation; the apparatus is built with the capability of generating pre-determined pattern by step movement of radiators and /or the material sensitive to used radiation in the plane parallel to radiation-sensitive material either in the same direction or in two mutually perpendicular directions wherein the radiators are made as radiators array or compose array including N radiator arrays; the size of radiators array or compose array is either equal to or more than the size of pre-determined image on the material sensitive to used radiation, and diameter d of radiation flow from each radiator is less than 100 nm; the pre-determined pattern is generated by step movement of the array or compose array and /or the material sensitive to used radiation in the plane parallel to radiation-sensitive material at a pitch less than d to the distances not exceeding maximum distance between the axes of adjacent radiators.

15. The apparatus according to i.14, wherein the movement pitch is from 0.01 nm to 1 nm.

16. The apparatus according to i.14, wherein diameter d of radiation flow from each radiator is from 10 nm to 50 nm.

17. The apparatus according to i.14, **wherein** the apparatus is built with the capability to control radiation flow from each radiator and/or change the movement pitch.

18. The apparatus according to i.14, wherein the apparatus is built with the capability to control the setting of radiator array at pre-defined distance z from the surface of the material sensitive to used radiation by moving radiator array or compose array and /or the material sensitive to used radiation in the direction perpendicular to the surface of radiation-sensitive material at a pitch from 0.01 nm to d.

19. The apparatus according to i.18, **wherein** the apparatus is built with the capability of changing the movement pitch.

20. The apparatus according to i. 18, wherein the distance z between the radiators array or compose array and the material sensitive to used radiation is from 1 nm to 5000 nm.

21. The apparatus according to i. 18, wherein the distance z between the radiators array or compose array and the material sensitive to used radiation is from 1 nm to d.

22. The apparatus as in any of items 14-21, wherein each radiator array is made as waveguide array connected to at least one radiation source, the waveguides are made of fiber optic waveguides with thinned ends coated with the layer reflecting the passing radiation.

23. The apparatus as in any of items 14-21, wherein any of radiator array is represented as an array of waveguides connected to at least one radiation source and shaped as microcones made of the material transparent to used radiation, wherein the radius of rounding at microcones vertex directed towards the material sensitive to used radiation is equal to half of radiation flow diameter d at the output of each radiator, wherein the microcones are coated with the layer reflecting the passing radiation.

24. The apparatus as in any of items 14-21, wherein any of radiator arrays is represented as an array of field emission emitters connected to at least one current source.

25. The apparatus according to i. 24, wherein field emission emitter array or compose array and the material sensitive to used radiation are placed in the magnetic field directed along longitudinal axes of field emission emitters.

26. The apparatus according to i. 25, wherein the distance z between field emission emitter array and the material sensitive to used radiation does not exceed the distance, at which the created magnetic field provides larmor radius of emitted electron bunch on the surface of material sensitive to used radiation does not exceeding pre-defined exposure spot radius on the surface of the material sensitive to used radiation.

27. An apparatus for pattern generation on the material sensitive to used radiation composed of radiators; the radiators and/or substrate with radiation-sensitive material are set with the capability of moving relative to each other, wherein the radiators are represented as at least one radiation source connected to at least one waveguide; the waveguides are made as fiber optic waveguides with thinned ends or shaped as microcones made of the material transparent to radiation passing; the diameter d of the radiation flow from each radiator is less than 100 nm and the radiators and/or the substrate with radiation-sensitive material are set with the capability of moving relative to each other with a pitch less than d.

28. The apparatus according to i. 27, wherein the diameters of thinned ends of optic waveguides or radius of rounding at microcones vertex directed towards the material sensitive to used radiation are from 10 nm to 50 nm.

29. The apparatus according to i. 27, wherein XYZ-nanopositioner is introduced; the nanopositioner is set with the capability of moving radiators and substrate with radiation-sensitive material at a pitch 0.01 nm.

**30.** The apparatus according to i. 27, wherein the distance z between the waveguides and the material sensitive to used radiation is from 1 nm to 2000 nm.

**31.** The apparatus as in i.30, **wherein** in order to provide the resolutions $\Delta x \approx d$ the distance between the waveguides and the material sensitive to used radiation does not exceed d.

**32.** The apparatus as in any of items 27-31, wherein the apparatus is built with the capability to switch the light flow passing through the waveguides.

**33.** The apparatus according to i.32, wherein the waveguides are shaped as microcones; these microcones are made of silicon or compounds like $A_{III}B_V$ or $A_{II}B_{VI}$ and on their basis solid state switching nanolasers and waveguides are built that generate pre-determined radiation or individually switching gate devices controlling radiation access to microcones.

**34.** The apparatus according to i. 32, wherein the microcones are placed on the surface of respective planar waveguides.

**35.** The apparatus as in any of items 27-31, wherein the waveguides form at least one two-dimensional array composed of several rows, several waveguides in each row.

**36.** The apparatus as in any of items 27-31, wherein the size of waveguides array or N waveguide arrays is equal to or more than the size of pre-determined image on the material sensitive to used radiation; the radiators and/or substrate with radiation-sensitive material are set with the capability of moving to the distances do not exceeding maximum distance between the axes of adjacent radiators.

**37.** The apparatus as in any of items 27-31, wherein the apparatus is built with the capability to change the movement pitch.

**38.** An apparatus of pattern generation on the material sensitive to used radiation composed of at least one radiator represented as field emission emitter connected to the current source, substrate with radiation-sensitive material and the source of magnetic field; the substrate with radiation-sensitive material and/or at least one field emission emitter are set with the capability to move relative to each other, wherein the substrate with radiation-sensitive material and all field emission emitters are placed in the magnetic field directed along the longitudinal axis of each field emission emitter whisker; diameter d of radiation flow from each field emission emitter is less than 100 nm; the field emission emitters and /or the substrate with radiation-sensitive material are set with the capability to move relative to each other at a pitch less than d.

**39.** The apparatus according to i.38, wherein XYZ-nanopositioner is introduced; the nanopositioner is set with the capability of moving field emission emitters or substrate with radiation-sensitive material with a pitch 0.01 nm.

**40.** The apparatus according to i. 39, wherein diameter d of radiation flow from each radiator is from 10 nm to 50 nm.

**41.** The apparatus according to i.38, wherein the distance z between emission emitters and the material sensitive to used radiation does not exceed the distance at which formed magnetic field provides larmor radius of emitted electron bunch on the surface of material sensitive to used radiation does not exceeding pre-determined exposure spot radius on the surface of the radiation-sensitive material.

**42.** The apparatus according to i.38, **wherein** all field emission emitters are placed at a distance z larger than several millimeters from the surface of the material sensitive to used radiation.

**43.** The apparatus according to i.38, **wherein** all field emission emitters are placed at a distance from 1 nm to 5000 nm from the surface of the material sensitive to used radiation.

**44.** The apparatus according to i. 38, wherein all field emission emitters are made with the capability to switch emitted current and/or change the movement pitch.

**45.** The apparatus as in any of items 38-44, wherein field emission emitters form at least one two-dimensional array of several rows with several field emission emitters in each row.

**46.** The apparatus as in any of items 38-44, wherein the size of field emission emitters array or field emission emitters N arrays is equal to or more than the size of pre-determined image on the radiation-sensitive material; the field emission emitters and /or the radiation-sensitive material are set with the capability to move to the distances not exceeding the maximum distances between the axes of adjacent field emission emitters.

**47.** A method of pattern generation on the material sensitive to used radiation where exposure spots are generated on radiation-sensitive material by radiators; pre-determined image is generated by step movement of radiators and /or the material sensitive to used radiation in the plane parallel to radiation-sensitive material either in the same direction or in two mutually perpendicular directions, wherein the radiators are represented as radiators array or compose array including N radiator arrays; the diameter d of radiation flow from each radiator is less than 100 nm; the radiators and /or the material sensitive to used radiation are continuously moving step-by- step at a pitch less than d; the pulse time of radiation from each radiator is controlled to ensure that during radiation pulse from at least one radiator having the least duration the radiators and radiation - sensitive material move relative to each other at a value do not exceeding pre-determined value.

**48.** The method according to i. 47, wherein during radiation pulse from at least one radiator having the least duration $\Delta S$ radiators and the material sensitive to used radiation move relative to each other at value not exceeding $0,01d_1$, where $d_1$ is the diameter of exposure spot when radiators and radiation-sensitive material are static.

**49.** The method according to i. 47, wherein the size of radiator array or compose array is equal to or more than the size of pre-determined image on radiation-sensitive material, and radiators and/or the material sensitive to used radiation are continuously moving step-by- step to distances not exceeding maximum distances between the axes of adjacent radiators.

**50.** The method according to i. 47 or i. 48, wherein step movement is at pitch from 0.01 nm to 1 nm.

**51.** The method according to i. 47 or i. 48, wherein diameter d of radiation flow from each radiator is from 10 nm to 50 nm.

**52.** The method according to i. 47 or i. 48, wherein the required size of exposure spots on the surface of radiation-sensitive material is achieved by placing radiators at pre-determined distance z from the surface of radiation-sensitive material by step movement of radiators and/or radiation-sensitive material in the direction perpendicular to the surface of radiation-sensitive material with a pitch less than d.

**53.** The method according to i. 52, wherein step movement is performed at pitch from 0.01 nm to 1 nm.

**54.** The method according to i. 52, wherein the distance z between the radiators array and the material sensitive to used radiation is from 1nm to 5000 nm.

**55.** The method according to i. 54, wherein the distance z between the radiators array and the material sensitive to used radiation is from 1 nm to d.

**56.** An apparatus for pattern generation on the material sensitive to used radiation composed of radiators and the substrate sensitive to used radiation; the apparatus is built with the capability of generating pre-determined pattern by step movement of radiators and /or the material sensitive to used radiation in the plane parallel to radiation-sensitive material either in the same direction or in two mutually perpendicular directions, wherein the radiators are represented as radiators array or compose array including N radiator arrays; diameter d of radiation flow from each radiator is less than 100 nm; the radiators and /or the material sensitive to used radiation are placed to provide continuous step movement with a pitch less than d; the apparatus is built with the capability to control radiation pulse time from each radiator to ensure that during radiation pulse from at least one radiator having the least duration the radiators and radiation - sensitive material move relative to each other at a value do not exceeding pre-determined value.

**57.** The apparatus according to i.56, wherein during radiation pulse from at least one radiator having the least duration $\Delta S$ radiators and the material sensitive to used radiation move relative to each other at value not exceeding $0,0d_1$, where $d_1$ is the diameter of exposure spot when radiators and radiation-sensitive material are static.

**58.** The apparatus according to i.56, wherein the size of radiator array or compose array is equal to or more than the size of pre-determined image on radiation-sensitive material, and radiators and/or the material sensitive to used radiation are set with the capability to continuously move step-by- step to distances not exceeding maximum distances between the axes of adjacent radiators.

59. The apparatus according to i.56, **wherein** movement **pitch** is from 0.01 nm to1 nm.

60. The apparatus according to i.56, wherein diameter d of radiation flow from each radiator is from 10 nm to 50 nm.

61. The apparatus according to i.56, wherein the apparatus is built with the capability of changing movement pitch.

62. The apparatus according to i.56, wherein the apparatus is built with the capability of placing radiator array or compose array at pre-determined distance z from the surface of radiation-sensitive material by moving radiators and /or radiation-sensitive material in the direction perpendicular to the surface of radiation-sensitive material with a pitch from 0.01 nm to d.

63. The apparatus according to i. 62, wherein the apparatus is built with the capability of changing movement pitch.

64. The apparatus according to i. 62, wherein the distance z between the radiator array or compose array and the material sensitive to used radiation is from 1 nm to 5000 nm.

65. The apparatus according to i. 62, wherein the distance z between the radiator array or compose array and the material sensitive to used radiation is from 1 nm to d.

Fig. 1

**Fig. 2**

**INTERNATIONAL SEARCH REPORT**

| | International application No. |
| --- | --- |
| | PCT/RU 2004/000273 |

| A. CLASSIFICATION OF SUBJECT MATTER |
| --- |
| G03F 7/20 |
| According to International Patent Classification (IPC) or to both national classification and IPC |

| B. FIELDS SEARCHED |
| --- |
| Minimum documentation searched (classification system followed by classification symbols) |
| G03F 7/20-7/24, H01J 3/00-3/40, 37/00, 37/073, 37/20-37/24, H01L 21/00-21/033, 21/64, 21/66, 21/70, 21/77 |
| Documentation searched other than minimum documentation to the extent that such documents are included in the fields searched |
| Electronic data base consulted during the international search (name of data base and, where practicable, search terms used) |

| C. DOCUMENTS CONSIDERED TO BE RELEVANT | | |
| --- | --- | --- |
| Category* | Citation of document, with indication, where appropriate, of the relevant passages | Relevant to claim No. |
| A | US 6586169 B2 (DEUTSCHES ZENTRUM FUER LUFT- UND RAUMFAHRT E. V.) 01. 07. 2003, the claims | 1-65 |
| A | US 6498349 B1 (UT-BATTELLE) 24. 12. 2002, the claims, figure 4 | 1-65 |
| A | WO 2003/036767 A2 (THE BOARD OF TRUSTEES OF THE UNIVERSITY OF ILLINOIS) 01. 05. 2003, the claims, figure 2 | 1-65 |
| A | RU 2029980 C1 (TSENTRALNY NAUCHNO-ISSLEDOVATELSKY INSTITUT "ELEKTRON") 27.02.1995, the abstract | 1-65 |

| ☐ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| (20. 09. 2004) | (21. 10. 2004) |

| Name and mailing address of the ISA/ | Authorized officer |
| --- | --- |
| **RU** | |
| Facsimile No. | Telephone No. |

Form PCT/ISA/210 (second sheet) (July 1992)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0060632 A

### Non-patent literature cited in the description

- **E.BETZIG ; J.K.TRAUTMAN.** *Science,* 1991, vol. 251, 1468
- **YU. D. CHISTYAKOV ; YU. P. RAINOVA.** *Physical and Chemical Fundamentals of Microelectronic Technology,* 1979
- **E.I. GIVARGIZOV.** *Whiskers and Plate Chips Vapor Deposition, Science,* 1977
- **CHARLES LIEBER.** *CERN Courier,* May 2003
- *Appl.Phys.Let,* 12 October 1998, vol. 73 (15), 2090-2092